Europäisches Patentamt

**European Patent Office**

**Office européen des brevets**

(19)

(11) Numéro de publication: **0 033 682**
A2

(12)

# DEMANDE DE BREVET EUROPEEN

(21) Numéro de dépôt: **81400098.0**

(22) Date de dépôt: **23.01.81**

(51) Int. Cl.³: **H 01 L 31/06**
**H 01 L 25/08**

(30) Priorité: **01.02.80 FR 8002253**

(43) Date de publication de la demande:
**12.08.81 Bulletin 81/32**

(84) Etats contractants désignés:
**DE FR GB IT NL**

(71) Demandeur "LE SILICIUM SEMICONDUCTEUR SSC"
45, rue de Monceau
F-75008 Paris(FR)

(72) Inventeur. **Arnould, Jacques**
**THOMSON-CSF SCPI 173, bld Haussmann**
**F-75360 Paris Cedex 08(FR)**

(74) Mandataire: **de Beaumont, Michel et al,**
**"THOMSON-CSF" SCPI 173, Bld Haussmann**
**F-75360 Paris Cedex 08(FR)**

(54) **Procédé de montage d'une diode de protection sur une structure de cellules photovoltaiques multijonctions verticales et cellules photovoltaiques obtenues.**

(57) La présente invention concerne un montage de diodes de protection sur une structure de cellules photovoltaïques multijonctions verticales.

Etant donné un empilement de diodes 10 constituant une cellule photovoltaïque multijonctions verticales, la présente invention consiste à solidariser de cet empilement une diode en inverse 30, en intercalant éventuellement une plaquette de matériau conducteur 31.

Application aux cellules solaires fonctionnant en lumière concentrée.

Fig.5

EP 0 033 682 A2

Croydon Printing Company Ltd

0033682

PROCEDE DE MONTAGE D'UNE DIODE DE PROTECTION SUR UNE
STRUCTURE DE CELLULES PHOTOVOLTAIQUES MULTIJONCTIONS
VERTICALES ET CELLULES PHOTOVOLTAIQUES OBTENUES.

La présente invention concerne un procédé de montage d'une diode de protection sur une structure de diodes photovoltaïques verticales et une cellule photovoltaïque obtenue par ce procédé.

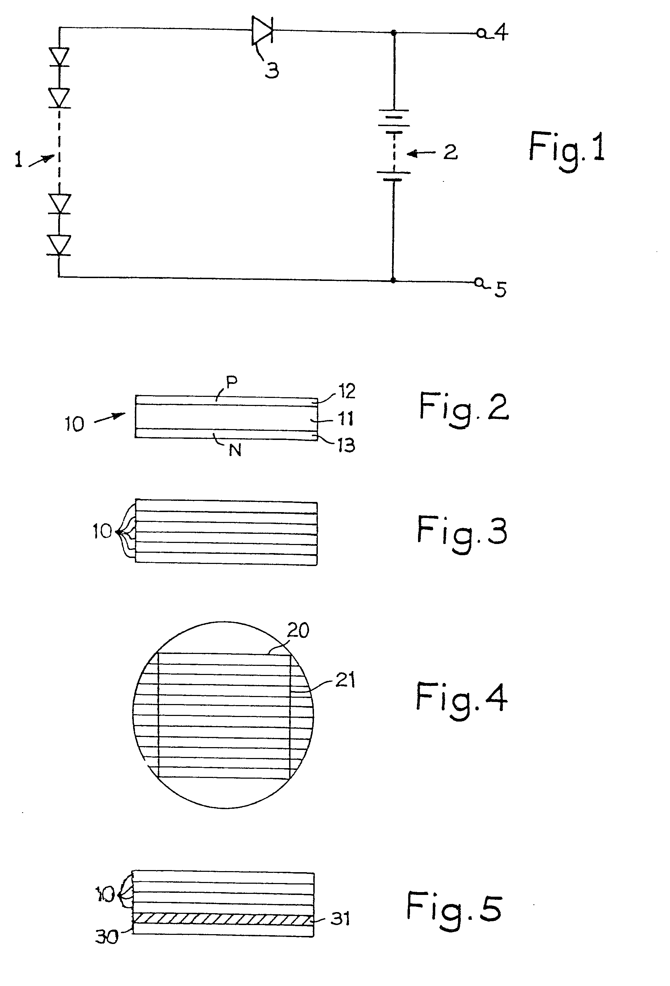

La figure 1 représente schématiquement un montage classique de cellule solaire. Un ensemble de diodes photovoltaïques en série 1 débite sur une batterie d'accumulateurs 2 servant de batterie tampon pour permettre de continuer à fournir de l'énergie quand les cellules solaires 1 ne sont pas éclairées. Il est en outre nécessaire de prévoir une diode de protection 3 pour que, quand les diodes photovoltaïques 1 ne sont pas éclairées, la batterie 2 ne se décharge pas par ces diodes.

Dans la pratique, on distingue deux grands groupes de cellules solaires, les cellules solaires fonctionnant en lumière normale et les cellules solaires fonctionnant en lumière concentrée. Parmi ces dernières, on s'intéressera ici plus particulièrement aux cellules multijonctions verticales à éclairage latéral, qui sont par exemple décrites dans l'article de B.L. Sater et al. paru dans l'ouvrage intitulé Solar Cells édité par C.E. Backus aux I.E.E.E. Press en 1976.

On va rappeler rapidement en relation avec les figures 2, 3 et 4 la structure de telles diodes à multijonctions verticales. Cette structure est fabriquée à partir de plaquettes de silicium 10 comprenant un substrat 11 à faible niveau de dopage revêtu sur chacune de ses faces d'une couche de type de conductivité opposé (respectivement P et N 12 et 13).

Comme le représente également en vue de côté la figure 3 un grand nombre de plaquettes 10 est ensuite empilé et ces plaquettes sont fixées les unes aux autres par alliage métallique. Comme le représente la vue de dessus de la figure 4, cet empilage de plaquettes est ensuite découpé par exemple à la scie, selon les lignes désignées par les références 20 et 21. On obtient ainsi un

2

ensemble de barrettes ou cellules élémentaires à multijonctions verticales qui peut être utilisé en lumière concentrée par éclairage latéral. Ensuite, étant donné que la hauteur de l'empilage, qui peut être relativement élevée et comprendre plus de 100 plaquettes, est néanmoins limitée, on peut vouloir monter en série ou en parallèle, un ensemble de cellules élémentaires telles que celles obtenues à la suite de l'opération décrite en relation avec la figure 4.

La cellule élémentaire ou l'ensemble de cellules élémentaires monté en série ou en parallèle correspond à l'ensemble 1 représenté en figure 1. Il s'agit alors de connecter à cet ensemble la diode 3 ce qui, de façon classique, est fait par une connexion externe dans les dispositifs de l'art antérieur. En outre, dans le cas où plusieurs cellules élémentaires sont montées en parallèle, si on veut éviter des risques de décharge d'un ensemble de cellules dans un autre au cas où l'un de ces ensembles élémentaires ne serait pas éclairé convenablement, il convient de disposer des diodes en inverse telles que la diode 3 en série avec chaque cellule élémentaire avant de les monter en parallèle, ce qui complique considérablement les opérations de montage.

Ainsi, un objet de la présente invention est de prévoir un procédé de montage d'une diode de protection en inverse sur une structure de cellule photovoltaïque à multijonctions verticales qui simplifie le mode de montage et évite à l'utilisateur toute erreur éventuelle de montage.

Pour atteindre cet objet ainsi que d'autres, la présente invention prévoit un procédé de montage d'une diode de protection sur une structure de diodes photovoltaïques multijonctions verticales consistant à empiler des plaquettes de diodes photovoltaïques de même orientation, à les solidariser entre elles, et à découper cet empilage en barrettes perpendiculairement à la direction des plaquettes comprenant en outre, avant l'étape de découpe de l'empilage, une étape consistant à disposer sur l'empilement une plaquette de diode de polarité inverse de celle des autres diodes et à solidariser cette diode de l'empilement. Une plaquette conductrice peut être insérée en série entre l'empilement de dio-

3

des photovoltaïques et la diode en inverse. Cette plaquette conductrice peut être une plaquette de silicium fortement dopée. La
plaquette de diode montée en inverse peut être identique aux autres plaquettes de l'empilement et en différer seulement par son
orientation.

Ainsi, la présente invention concerne une cellule photovoltaïque intégrée sous forme d'une barrette comprenant un empilement de diodes photovoltaïques de même polarité comprenant en
outre une diode en inverse solidaire des autres diodes.

Les figures 1 à 4 ont déjà été décrites précédemment et
étaient destinées à exposer le contexte dans lequel s'insère la
présente invention.

La figure 5 illustre de façon très schématique un mode de
réalisation de la présente invention.

La figure 5 représente en coupe un empilement de diodes
10 tel que l'empilement déjà représenté en figure 3. En plus de
cet empilement, est prévue une plaquette de diode supplémentaire
fixée à l'empilement 10 avec une polarité inverse de celle des autres diodes constituant l'empilement. Ensuite, l'empilement des
plaquettes est découpé de la manière exposée précédemment en relation avec la figure 4 et l'on obtient donc une diode de protection
intégrée avec une cellule de diodes photovoltaïques multijonctions
verticales élémentaires.

Comme le représente également la figure 5, la diode 30
peut être fixée à l'empilement de diodes 10 par l'intermédiaire
d'une plaquette intercalaire 31 d'épaisseur nettement supérieure à
l'épaisseur des intercalaires utilisés entre les diodes élémentaires 10 pour les fixer les unes aux autres. Cette plaquette intercalaire doit être en un matériau conducteur et peut par exemple
être constituée d'une plaquette de silicium fortement dopée.
Ainsi, en utilisation, on pourra éventuellement disposer
l'ensemble illustré en figure 5 de façon que la jonction de la
diode 30 ne soit pas éclairée, ce qui permet de réduire légèrement la chute de tension provoquée par cette diode.

La diode 30 peut être du même type que les autres diodes
de la cellule multijonctions verticales ou bien être fabriquée sé-

4

parément pour optimiser ses caractéristiques de chute de tension en direct et de fuite en inverse.

La présente invention n'est pas limitée aux modes de réalisation qui ont été explicitement décrits ci-dessus; mais en comprend les diverses variantes et généralisations incluses dans le domaine des revendications ci-après.

5

REVENDICATIONS

1. Procédé de montage d'une diode de protection sur une structure de cellules photovoltaïques multijonctions verticales consistant à empiler des plaquettes de diodes photovoltaïques de même orientation, à les solidariser entre elles, et à les découper en barrettes perpendiculaires à la direction des plaquettes, caractérisé en ce qu'il comprend, avant l'étape de découpe, une étape consistant à disposer sur l'empilement une plaquette de diode de polarité inverse de celles des autres diodes, et à solidariser cette diode de l'empilement.

2. Procédé selon la revendication 1, caractérisé en ce qu'il comprend l'étape consistant à insérer une plaquette conductrice entre l'empilement de diodes photovoltaïques et la diode en inverse.

3. Procédé selon la revendication 2, caractérisé en ce que la plaquette conductrice est une plaquette de silicium fortement dopée.

4. Procédé selon l'une quelconque des revendications 1 à 3, caractérisé en ce que la plaquette de diodes en inverse est identique aux autres plaquettes de l'empilement.

5. Cellule photovoltaïque intégrée du type à multijonctions verticales sous forme d'une barrette comprenant un empilement de diodes photovoltaïques, caractérisée en ce qu'elle comprend en outre une diode en inverse solidaire des autres diodes.

Fig.1

Fig.2

Fig.3

Fig.4

Fig.5